# EUROPEAN PATENT APPLICATION

(11) **EP 4 790 347 A1**
(43) Date of publication of application: **12.08.2026**
(21) Application number: 24874714.9
(22) Date of filing: 03.10.2024
(51) Int. Cl.: F28D 15/02

(54) **HEAT EXCHANGER, EVAPORATOR, DEVICE, AND MOVING BODY**

(30) Priority: 06.10.2023 JP 2023174640; 06.10.2023 JP 2023174641
(60) Divisional application: 26182875.0
(71) Applicant: NATIONAL UNIVERSITY CORPORATION TOKAI NATIONAL HIGHER EDUCATION AND RESEARCH SYSTEM, Nagoya-shi, Aichi 464-8601 (JP); Porite Corporation, Saitama 362-0806 (JP)
(72) Inventor: NAGANO, Hosei, Nagoya-shi, Aichi 464-8601 (JP); WATANABE, Noriyuki, Nagoya-shi, Aichi 464-8601 (JP); SUGIMOTO, Haruki, Nagoya-shi, Aichi 464-8601 (JP); TANABE, Shigeyuki, Kitaadachi-gun, Saitama 362-0806 (JP); ASO, Shinobu, Kitaadachi-gun, Saitama 362-0806 (JP); SADAKATA, Kazuki, Kitaadachi-gun, Saitama 362-0806 (JP)
(74) Representative: Kuhnen & Wacker Patent- und Rechtsanwaltsbüro PartG mbB
(86) International application number: PCT/JP2024/035538
(87) International publication number: WO 2025/075114

(57) **Abstract**

The present disclosure provides a heat exchanger including an evaporator having an evaporating body configured to evaporate a liquid-phase working fluid into a gas phase while moving it by capillary forces, the heat exchanger being configured to condense the gas-phase working fluid and circulate the liquid-phase working fluid back into the evaporator. The evaporator has its interior partitioned by the evaporating body and includes: a liquid-phase fluid accommodation chamber, provided on one side of the evaporating body, configured to accommodate the liquid-phase working fluid; and a gas-phase fluid accommodation chamber, provided on an opposite side of the evaporating body, configured to accommodate the gas-phase working fluid. The evaporator includes a pressing member configured to press a side surface of the evaporating body. The evaporating body includes a pressed portion to be pressed by the pressing member and having higher toughness than a portion thereof not pressed by the pressing member.

## Description

### Technical Field

The present disclosure relates to a heat exchanger, an evaporator, a device, and a moving body.

### Background Art

Patent Document 1 discloses a loop heat pipe including an evaporator, a condenser, and a liquid return pipe provided therein as well as a wick that generates capillary forces in order to efficiently cool heating components regardless of an installation angle.

### Citation List

### Patent Literature

Patent Document 1: Japanese Patent Application Laid-Open Publication No. 2008-215702

### Summary of Invention

### Technical Problem

In recent years, the development of electric vehicles has been actively pursued as one of the measures for environmental protection. Such development of electric vehicles has been accompanied by improvements in the performance of semiconductors that control motors of electric vehicles. However, such improvements in semiconductor performance lead to an increase in the amount of heat generated by semiconductors, resulting in a need for, among others, a heat exchanger that can remove heat flux from semiconductors with high efficiency.

Heat exchangers and other devices provided in automobiles may suffer damage to, for example, an evaporating body due to external impacts or other forces.

Accordingly, it is an object of the techniques disclosed herein to provide a heat exchanger and other devices that help prevent damage to the evaporating body.

### Solution to Problem

With the above object in mind, the techniques disclosed herein relate to a heat exchanger including an evaporator provided with an evaporating body, the evaporating body being configured to absorb heat from outside and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator. The evaporator has an interior thereof partitioned by the evaporating body and includes: a liquid-phase fluid accommodation chamber provided on one side of the evaporating body and configured to accommodate the working fluid in the liquid phase; and a gas-phase fluid accommodation chamber provided on an opposite side of the evaporating body from the liquid-phase fluid accommodation chamber and configured to accommodate the working fluid in the gas phase. The evaporator includes a pressing member provided closer to the liquid-phase fluid accommodation chamber with respect to the evaporating body and configured to press a side surface of the evaporating body facing the liquid-phase fluid accommodation chamber. The evaporating body includes a pressed portion configured to be pressed by the pressing member, the pressed portion having higher toughness than a portion of the evaporating body that is not pressed by the pressing member.

### Advantageous Effects of Invention

The techniques disclosed herein can provide a heat exchanger and other devices that help prevent damage to the evaporating body.

### Brief Description of Drawings

FIG. 1 illustrates a schematic configuration of an automobile.
FIG. 2 is a perspective view of an evaporator according to an exemplary embodiment.
FIG. 3 is an exploded perspective view of the evaporator according to the exemplary embodiment.
FIG. 4 is an exploded perspective view of a liquid-phase fluid container.
FIG. 5 is an exploded perspective view of a wick container.
FIG. 6 illustrates a detailed configuration of a housed body.
FIG. 7 is a schematic cross-sectional view taken along line VII-VII in FIG. 2.
FIG. 8 illustrates the arrangement of the evaporator.
FIG. 9 illustrates a first modification.
FIG. 10 illustrates a second modification.
FIG. 11 illustrates a third modification.

### Description of Embodiments

An exemplary embodiment will now be described in detail with reference to the appended drawings.

### <Configuration of Automobile 1>

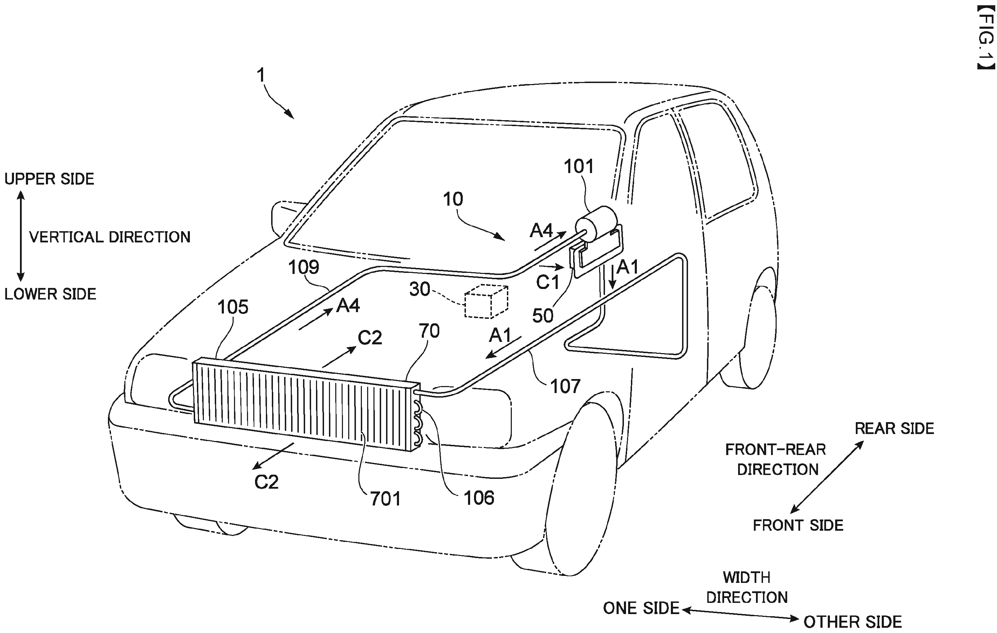

FIG. 1 illustrates a schematic configuration of an automobile 1.

First, referring to FIG. 1, a schematic configuration of an automobile 1 according to the present embodiment will be described.

The automobile 1 is a so-called electric vehicle. The automobile 1 includes a heating element 50 and a loop heat pipe 10 configured to cool the heating element 50.

The heating element 50 is a control device configured to control a motor 30 provided in the automobile 1. To further illustrate, the heating element 50 is a drive element of an inverter for driving the motor 30. The heating element 50 is composed of, for example, a SiC semiconductor.

The loop heat pipe 10 is an example of the cooling element. The loop heat pipe 10 is configured to circulate a working fluid therein to cool the heating element 50 without external power supply.

More specifically, the loop heat pipe 10 includes an evaporator 101 configured to evaporate the working fluid using the latent heat of vaporization of the working fluid to thereby cool the heating element 50, and a condenser 105 configured to release heat from the working fluid vaporized in the evaporator 101 via a heat dissipator 70 to thereby liquefy the working fluid.

The loop heat pipe 10 further includes a vapor line 107 configured to deliver the working fluid vaporized in the evaporator 101 to the condenser 105, and a liquid line 109 configured to deliver the working fluid liquefied in the condenser 105 to the evaporator 101. The loop heat pipe 10 is filled with the working fluid that changes between liquid and gas phases. For example, the working fluid may be water, alcohol, ammonia, etc.

The vapor line 107 and the liquid line 109 are transport lines configured to transport the working fluid. The vapor line 107 and the liquid line 109 are hollow members formed of stainless steel, resin, or the like. The vapor line 107 and the liquid line 109 may be configured to be bendable to facilitate their attachment to the automobile 1.

### <Operation of Loop Heat Pipe 10>

Referring now to FIG. 1, the operation of the loop heat pipe 10 will be described. First, heat generated in the heating element 50 is transferred to the evaporator 101 (see arrow C1). The working fluid having absorbed the heat in the evaporator 101 is vaporized and delivered through the vapor line 107 to the condenser 105 (see arrows A1). The working fluid delivered to the condenser 105 releases heat through the heat dissipator 70 (see arrows C2) and is liquefied. The liquefied working fluid is then delivered through the liquid line 109 back to the evaporator 101 as a so-called return liquid (see arrows A4).

As shown in FIG. 1, the condenser 105 is provided in thermal connection with the heat dissipator 70. The condenser 105 includes a condenser flow path 106 provided in a serpentine pattern. The heat dissipator 70 further includes fins 701 thermally connected to the condenser flow path 106. As the working fluid in the gas phase moves through the condenser flow path 106 and releases heat to the fins 701, the working fluid in the gas phase is liquefied.

The loop heat pipe 10 is a gas-liquid two-phase heat transport device that utilizes capillary force generated by a porous body. As described above, the loop heat pipe 10 cools the heating element 50, which is an inverter for motor control in the automobile 1.

For example, the allowable temperature and the maximum heat load of the loop heat pipe 10 may be, but are not limited to, 200°C and 3 kW, respectively. The transport distance of the loop heat pipe 10 may be 3 to 5 m. The loop heat pipe 10 utilizes the latent heat of the working fluid to enable highly efficient heat transport. Also, the loop heat pipe 10 can serve as a lightweight and compact cooling device. The loop heat pipe 10 utilizes capillary force and thus does not require electric power, which would otherwise be needed when using a pump (as opposed to the present embodiment), and also eliminates the need for pump maintenance. Furthermore, since the loop heat pipe 10 utilizes transport lines, it can be mounted using a mechanism common to currently mainstream liquid-cooling systems.

Hereinafter, the traveling direction of the automobile 1, i.e., the front-rear direction of the automobile 1 may simply be referred to as the "front-rear direction". The direction perpendicular to the front-rear direction, i.e., the width direction of the automobile 1 may simply be referred to as the "width direction". The direction perpendicular to both the front-rear direction and the width direction, i.e., the vertical direction of the automobile 1 may simply be referred to as the "vertical direction". It should be noted that the directional terms such as the front-rear direction as used herein are for convenience only and are not intended to limit the orientation in which the loop heat pipe 10 is installed.

### <Evaporator 101>

### (Schematic Configuration of Evaporator 101)

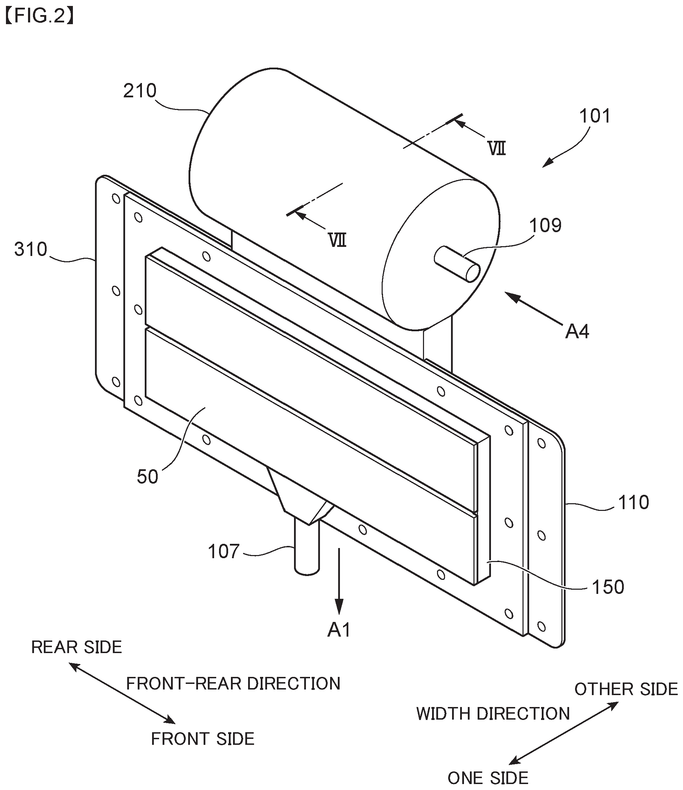

FIG. 2 is a perspective view of the evaporator 101 according to the present embodiment.

Referring next to FIG. 2, a schematic configuration of the evaporator 101 according to the present embodiment will be described.

As shown in FIG. 2, the evaporator 101 includes a compensation chamber 210 configured to accommodate the working fluid in a liquid phase, and an evaporator main body 310 provided below the compensation chamber 210 and configured to vaporize the working fluid in the liquid phase accommodated therein.

In the illustrated example, the compensation chamber 210 is a substantially cylindrical hollow member. The compensation chamber 210 is disposed with its axial direction, i.e., its longitudinal direction extending along the front-rear direction. This arrangement facilitates air flow around the outer periphery of the compensation chamber 210 during, for example, traveling of the automobile 1. This may help reduce an increase in temperature of the compensation chamber 210.

In the illustrated example, the evaporator main body 310 is a substantially plate-shaped member. The evaporator main body 310 is disposed with its plate surface extending along the front-rear direction. This arrangement facilitates air flow around the outer periphery of the evaporator main body 310 during, for example, traveling of the automobile 1. This may help reduce an increase in temperature of the evaporator main body 310.

### (Detailed Configuration of Evaporator 101)

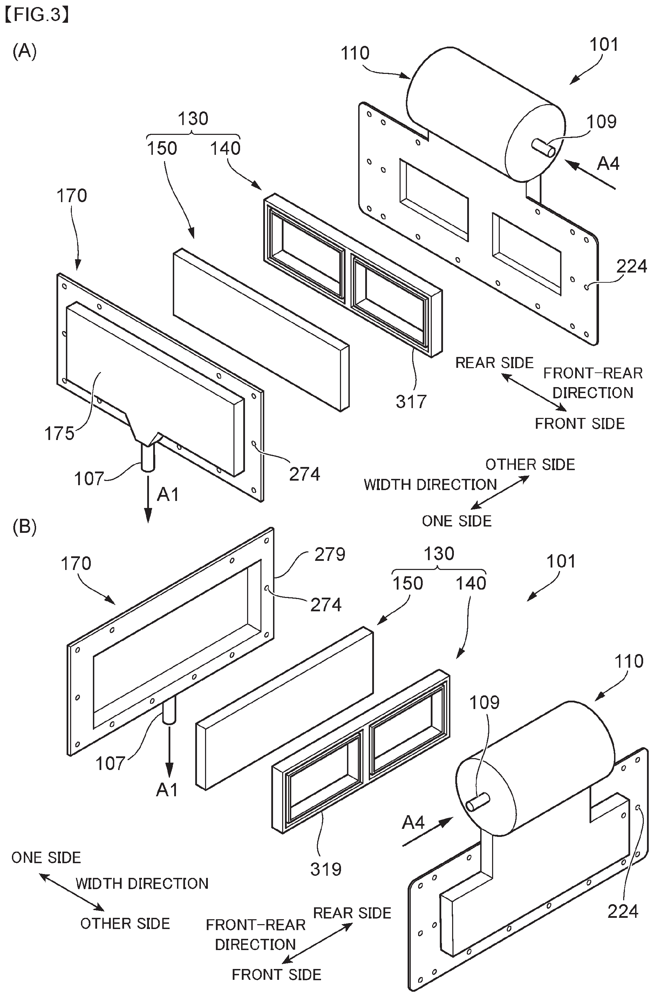

FIG. 3 is an exploded perspective view of the evaporator 101 according to the present embodiment. More specifically, FIG. 3(A) is an exploded perspective view as seen from one side in the width direction, and FIG. 3(B) is an exploded perspective view as seen from the other side in the width direction.

Referring next to FIG. 3, a detailed configuration of the evaporator 101 according to the present embodiment will be described.

The evaporator 101 includes a liquid-phase fluid container 110, a housed body 130 provided on one side of the liquid-phase fluid container 110 in the width direction, and a wick container 170 provided on one side of the housed body 130 in the width direction. The housed body 130 includes a spacer 140 and a wick 150 provided on one side of the spacer 140 in the width direction.

The liquid-phase fluid container 110 and the wick container 170 each have a flange structure and are secured to each other using bolts (not shown). To further illustrate, the housed body 130 is sandwiched between the liquid-phase fluid container 110 and the wick container 170. The liquid-phase fluid container 110 and the wick container 170 are secured to each other by inserting 6-mm diameter bolts (not shown) through through-holes 224 formed in the liquid-phase fluid container 110 and through-holes 274 formed in the wick container 170. The liquid-phase fluid container 110 and the wick container 170 constitute a housing that accommodates the housed body 130 therein. The liquid-phase fluid container 110 and the wick container 170 are formed of, for example, a metal such as stainless steel, or a resin or the like.

The heating element 50 (see FIG. 1) is provided on a heat-receiving surface 175, which is a surface of the wick container 170 facing one side in the width direction. To further illustrate, the heat-receiving surface 175 is provided in thermal connection with the heating element 50. As such, the evaporator 101 is configured to receive heat from the heating element 50 via the heat-receiving surface 175.

### <Liquid-Phase Fluid Container 110>

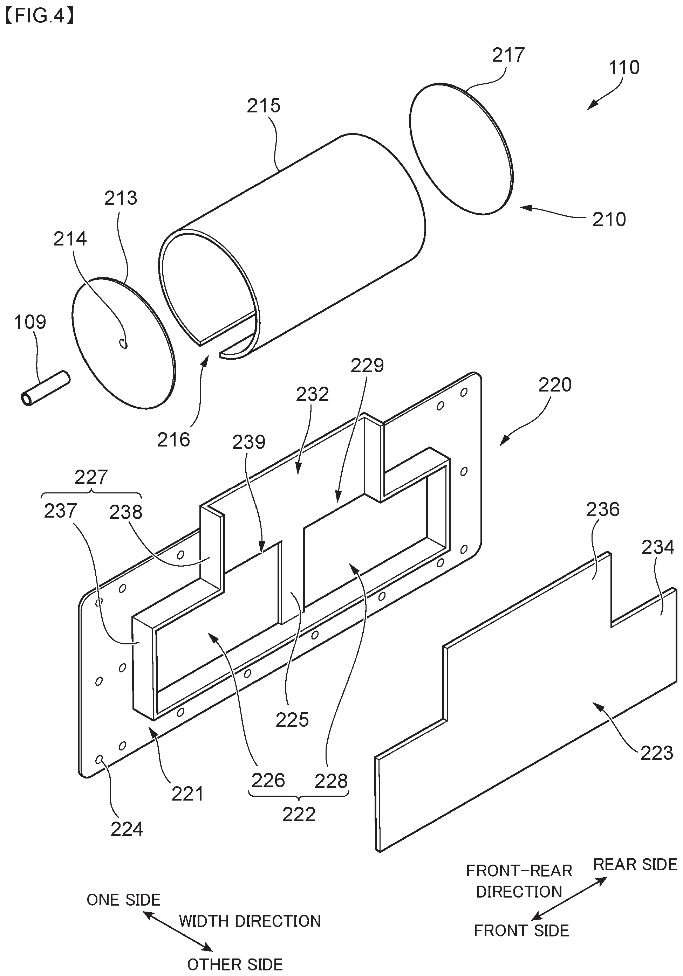

FIG. 4 is an exploded perspective view of the liquid-phase fluid container 110.

Referring next to FIG. 4, a detailed configuration of the liquid-phase fluid container 110 will be described.

The liquid-phase fluid container 110 includes the compensation chamber 210 and a liquid reservoir portion 220 provided below the compensation chamber 210 in the vertical direction. Components of the compensation chamber 210 and the liquid reservoir portion 220 are secured using a known method such as welding.

The compensation chamber 210 is a cylindrical member. The compensation chamber 210 includes a substantially disk-shaped first side plate 213, a cylindrical compensation chamber main body 215, and a substantially disk-shaped second side plate 217. The first side plate 213 has an inlet 214 formed as a through-hole at the center of the plate surface. The liquid line 109 is connected to the inlet 214. That is, the working fluid in the liquid phase flows into the compensation chamber 210 from the liquid line 109 through the inlet 214. The outer and inner diameters of the liquid line 109 may be, but are not limited to, 6 mm and 5 mm, respectively.

The compensation chamber main body 215 is formed with a compensation chamber-side opening 216 that opens downward. The compensation chamber-side opening 216 is a substantially rectangular slit with its longitudinal direction extending along the front-rear direction. The compensation chamber-side opening 216 is disposed so as to communicate with the interior of the liquid reservoir portion 220.

The liquid reservoir portion 220 is a plate-shaped structural member. In the illustrated example, the liquid reservoir portion 220 includes a liquid reservoir main body 221 and a liquid-side lid body 223 configured to cover the main body 221.

The liquid reservoir main body 221 is a plate-shaped member having a substantially rectangular shape in plan view. The liquid reservoir main body 221 includes a liquid-side opening 222 formed as a through-hole at the center of the plate surface, and multiple through-holes 224 formed around the liquid-side opening 222.

The liquid-side opening 222 has a substantially rectangular shape, with its dimension in the front-rear direction being larger than its dimension in the vertical direction. Here, the liquid reservoir main body 221 includes a bridging portion 225 formed at the center of the liquid-side opening 222 in the front-rear direction and extending along the vertical direction. Due to the provision of the bridging portion 225, the liquid-side opening 222 is divided into a first liquid-side opening 226 and a second liquid-side opening 228.

The liquid reservoir main body 221 includes a liquid-side frame body 227 on the other side of the liquid reservoir main body 221 in the width direction. The liquid-side frame body 227 is a frame body provided around the outer periphery of the liquid-side opening 222. In the illustrated example, the liquid-side frame body 227 includes a wide frame portion 237 and narrow frame portions 238 provided above the wide frame portion 237 in the vertical direction.

The wide frame portion 237 is a frame body configured to enclose the liquid-side opening 222. The wide frame portion 237 has a substantially rectangular shape in plan view. The wide frame portion 237 is formed with an upper-side opening 239 at the center of its upper side in the front-rear direction.

The narrow frame portions 238 are frame bodies disposed on opposite sides of the upper-side opening 239 formed in the wide frame portion 237, each extending in the vertical direction. The length between the narrow frame portions 238 in the front-rear direction is shorter than the length of the wide frame portion 237 in the front-rear direction. That is, the narrow frame portions 238 define a smaller width.

The liquid-side lid body 223 is a plate-shaped member having a substantially rectangular shape in plan view. The liquid-side lid body 223 includes a wide lid portion 234 and a narrow lid portion 236 provided above the wide lid portion 234 in the vertical direction. The wide lid portion 234 is shaped to cover the wide frame portion 237 of the liquid-side frame body 227. The narrow lid portion 236 is shaped to cover the narrow frame portions 238 of the liquid-side frame body 227. As the liquid-side frame body 227 is covered with the liquid-side lid body 223, a liquid-phase fluid accommodation region 229 is defined, which is a region in which the working fluid in the liquid phase is accommodated. The liquid-phase fluid accommodation region 229 is an example of the liquid reservoir region.

The liquid-phase fluid accommodation region 229 opens upward through a liquid reservoir-side opening 232. The liquid reservoir-side opening 232 faces the compensation chamber-side opening 216 and provides communication between the liquid-phase fluid accommodation region 229 and the interior of the compensation chamber 210.

### <Wick Container 170>

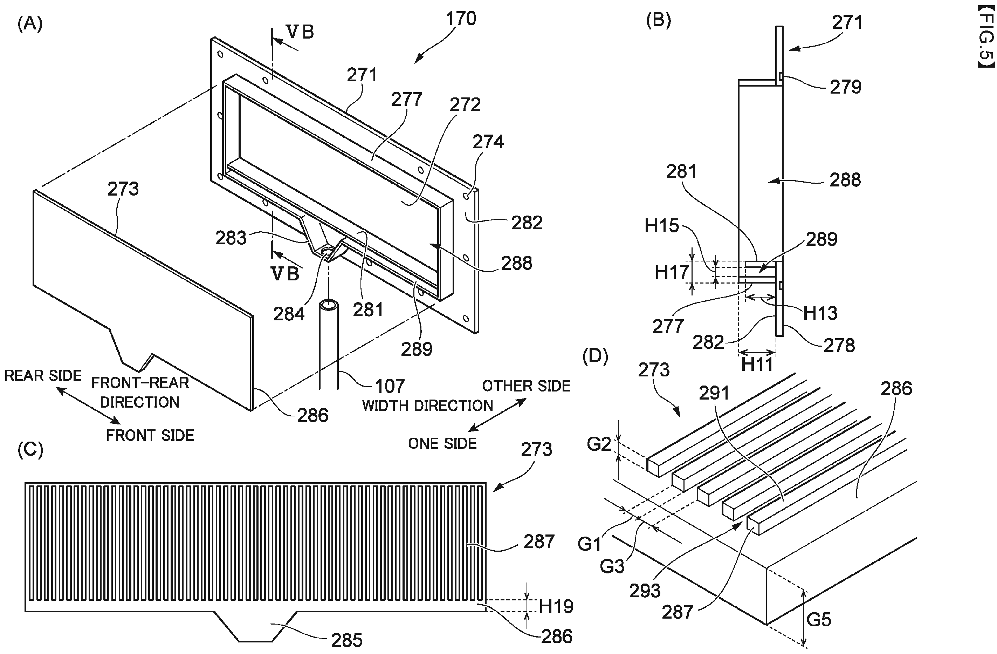

FIG. 5 is an exploded perspective view of the wick container 170.

Referring next to FIG. 5, a detailed configuration of the wick container 170 will be described.

First, as shown in FIG. 5(A), the wick container 170 includes a container main body 271 and a wick-side lid body 273 configured to cover the container main body 271. Components of the container main body 271 and the wick-side lid body 27 are secured using a known method such as welding.

The container main body 271 is a plate-shaped member having a substantially rectangular shape in plan view. The container main body 271 includes a wick-side opening 272 formed as a through-hole at the center of the plate surface, and multiple through-holes 274 formed around the wick-side opening 272. In the illustrated example, the wick-side opening 272 has a substantially rectangular shape, with its dimension in the front-rear direction being larger than its dimension in the vertical direction.

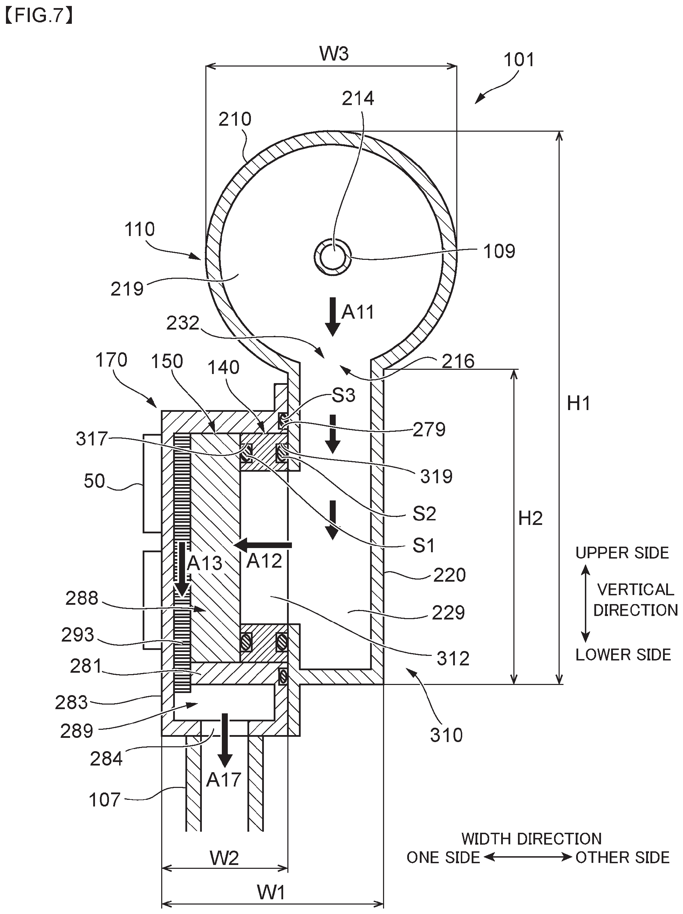

The container main body 271 is formed with an O-ring groove 279 on the other side surface 278 around the outer periphery of the wick-side opening 272 (see FIG. 5(B)). The O-ring groove 279 is a groove having a substantially rectangular shape in plan view, surrounding the outer periphery of the wick-side opening 272. An O-ring S3 (see FIG. 7 below) is disposed in the O-ring groove 279. The O-ring S3 is an annular sealing member having a substantially circular cross-section. The O-ring S3 may be, but is not limited to being, formed of a rubber material. Examples of the rubber material include silicone rubber, fluororubber, nitrile rubber, urethane rubber, butyl rubber, and styrenebutadiene rubber.

The container main body 271 further includes a wick-side frame body 277 on one side surface 282 around the outer periphery of the wick-side opening 272. The container main body 271 further includes a partition wall 281 inside the wick-side frame body 277 and located below the wick-side opening 272.

The wick-side frame body 277 is a frame body that surrounds the wick-side opening 272. The wick-side frame body 277 has a substantially rectangular shape in plan view. A space for forming the spacer 140 and the wick 150 is defined inside the wick-side frame body 277, details of which will be given later.

The partition wall 281 is a member that partitions the interior of the wick-side frame body 277. To further illustrate, the partition wall 281 partitions the interior of the wick-side frame body 277 into a wick accommodation region 288 located on an upper side and a gas-phase fluid guide region 289 located on a lower side (see FIG. 5(B)). The wick accommodation region 288 accommodates the spacer 140 and the wick 150 therein. The gas-phase fluid guide region 289 serves as a flow path for the working fluid in the gas phase (see FIG. 7 given below).

As shown in FIG. 5(A), the wick-side frame body 277 further includes a vapor guide portion 283 at a lower central portion in the front-rear direction. The vapor guide portion 283 protrudes downward in the vertical direction. The vapor guide portion 283 has an outlet 284 at its lower distal end. The vapor line 107 is connected to the outlet 284. The vapor guide portion 283 guides the working fluid in the gas phase flowing from the gas-phase fluid guide region 289 to the vapor line 107 through the outlet 284. The outer and inner diameters of the vapor line 107 may be, but are not limited to, 12 mm and 10 mm, respectively.

As shown in FIG. 5(C), the wick-side lid body 273 is a plate-shaped member having a substantially rectangular shape in plan view. The wick-side lid body 273 includes a guide cover portion 285 at a lower central portion in the front-rear direction. The guide cover portion 285 is in the form of a projection protruding downward in the vertical direction. The guide cover portion 285 covers the vapor guide portion 283 formed in the wick-side frame body 277.

As shown in FIG. 5(D), vapor guide protrusions 287 are formed on the other side surface 286 of the wick-side lid body 273. Multiple vapor guide protrusions 287 are formed on the other side surface 286, each extending in the vertical direction. A distal end 291 in a protruding direction of each vapor guide protrusion 287 has a flat surface. As the distal ends 291 of the respective vapor guide protrusions 287 are pressed against the plate surface of the wick 150, vapor grooves 293 are defined. Each vapor groove 293 is a space enclosed by adjacent vapor guide protrusions 287, the other side surface 286, and the wick 150. The vapor grooves 293 guide the working fluid in the gas phase flowing out from the wick 150 to the vapor guide portion 283 via the gas-phase fluid guide region 289.

Non-limiting example dimensions of the vapor guide protrusion 287 are as follows. Specifically, as shown in FIG. 5(D), a width G1 may be 0.1 mm to 5 mm, a height G2 may be 0.1 mm to 5 mm, and a gap G3 may be 0.1 mm to 5 mm. Note that a thickness G5 of the wick-side lid body 273 may be 0.5 mm to 10 mm.

Non-limiting example dimensions of the wick-side frame body 277 and other components are as follows. Specifically, as shown in FIGS. 5(B) and 5(C), a height H11 of the wick-side frame body 277 may be 14 mm, a height H13 of the partition wall 281 may be 13 mm, and a gap H15 between the wick-side frame body 277 and the partition wall 281 may be 2 mm. Each of the wick-side frame body 277 and the partition wall 281 may have a thickness of 2 mm, and a height H17 of the wick-side frame body 277 and the partition wall 281 across the gap H15 may be 6 mm. A distance H19 from the lower end of the wick-side lid body 273 to the vapor guide protrusions 287 may be 6 mm.

### <Housed body 130>

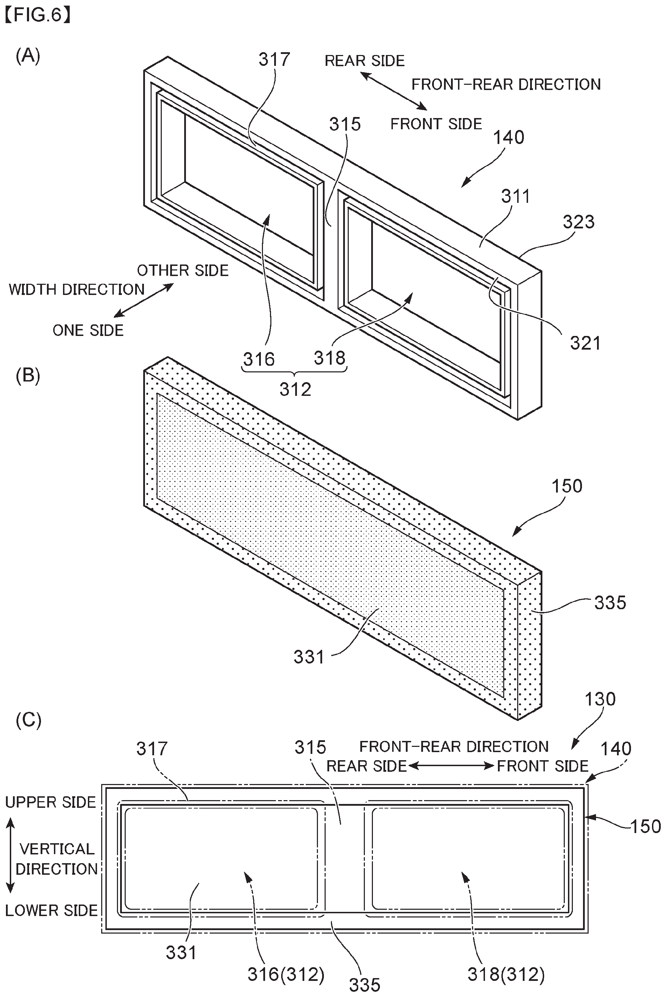

FIG. 6 illustrates a detailed configuration of the housed body 130.

Referring next to FIG. 6, a detailed configuration of the housed body 130 will be described.

As described above, the housed body 130 includes the spacer 140 and the wick 150. Configurations of the spacer 140 and the wick 150 will be described in order below.

### (Spacer 140)

First, referring to FIG. 6(A), the spacer 140 will be described. The spacer 140 is a frame body having a substantially rectangular shape in plan view. The spacer 140 supports the wick 150, which is disposed in overlapping relation to the spacer 140. To further illustrate, the spacer 140 presses an outer periphery of the plate surface of the wick 150. The spacer 140 includes a spacer opening 312 extending therethrough in the width direction. The spacer 140 further includes a bridging portion 315 formed at the center of the spacer opening 312 in the front-rear direction and extending in the vertical direction. Due to the provision of the bridging portion 315, the spacer opening 312 is divided into a first spacer opening 316 and a second spacer opening 318.

The bridging portion 315 holds a central portion of the wick 150 in the front-rear direction. In other words, the bridging portion 315 presses a central portion of the wick 150 in a longitudinal direction thereof. This enables the spacer 140 to more reliably seal the wick 150. Note that the surface of the bridging portion 315 opposite to the wick 150 is supported by the bridging portion 225 of the liquid reservoir portion 220 (see FIG. 4). This enables the spacer 140 to even more reliably seal the wick 150.

The bridging portion 315 is a support structure configured to support the spacer 140 internally. Accordingly, for example, even if a compressive force is applied to the spacer 140 in the vertical direction, the bridging portion 315 restrains deformation of the spacer 140. To further illustrate, even if a pressing force is applied to the spacer 140 and the wick 150 in the vertical direction, the bridging portion 315 helps prevent damage to the wick 150.

The spacer 140 includes O-ring grooves 317 and 319 on one side surface 321 and the other side surface 323, respectively. The O-ring grooves 317 and 319 surround the outer peripheries of the first spacer opening 316 and the second spacer opening 318. O-rings S1 and S2 are disposed in the O-ring grooves 317 and 319, respectively (see FIG. 7 given below).

For example, the spacer 140 is formed of a fluororesin (resin) such as polytetrafluoroethylene (PTFE), or a metal. The spacer 140 is preferably formed of a so-called low thermal conductivity material. To further illustrate, the spacer 140 is preferably formed of a material having a lower thermal conductivity than that of the liquid-phase fluid container 110 and the wick container 170.

### (Wick 150)

Referring next to FIG. 6(B), the wick 150 will be described. The wick 150 is a plate-shaped member having a substantially rectangular shape in plan view, elongated in the front-rear direction. Non-limiting example dimensions of the wick 150 are as follows: a length in the front-rear direction may be 30 mm to 900 mm, a length in the vertical direction may be 10 mm to 100 mm, and a length in the width direction may be 2 mm to 40 mm.

The wick 150 may be, but is not limited to being, formed of a porous body made of a porous metal such as stainless steel or copper. The wick 150 generates capillary forces in the working fluid, thereby causing the working fluid to move. The effective pore size of the wick 150 may be 0.1 µm to 20 µm, for example. The porosity of the wick 150 may be 25% to 70%, for example. Any suitable method may be used to measure the effective pore size and porosity. For example, the effective pore size and porosity may be measured based on apparent density measurement by water immersion, pore size distribution measurement by mercury porosimetry, or pore observation by X-ray CT.

In the present embodiment, the wick 150 has different structures at a central region of the plate surface and at an outer peripheral region thereof. More specifically, the wick 150 has different pore sizes between a central portion 331, which is a substantially rectangular region including the center of the wick 150, and an outer peripheral portion 335, which surrounds the outer periphery of the central portion 331 in a rectangular shape. To further illustrate, the central portion 331 has a relatively large pore size, while the outer peripheral portion 335 has a relatively small pore size. To further illustrate, the outer peripheral portion 335 has a smaller particle size than that of the central portion 331.

Reducing the pore size of the outer peripheral portion 335 results in relatively large flow resistance in the outer peripheral portion 335. Reducing the pore size of the outer peripheral portion 335 also results in relatively high strength of the outer peripheral portion 335. To further illustrate, the fracture strength of the outer peripheral portion 335 becomes relatively high. The toughness of the outer peripheral portion 335 also becomes relatively high. Furthermore, the rigidity of the outer peripheral portion 335 becomes relatively high. These properties help prevent damage to the wick 150 even when an external impact is applied thereto.

By way of non-limiting example, the effective pore size of the outer peripheral portion 335 may be 0 µm to 10 µm, while the effective pore size of the central portion 331 may be 0.2 µm to 20 µm. The porosity of the outer peripheral portion 335 may be 0% to 50%, while the porosity of the central portion 331 may be 20% to 80%. Note that the porosity of the outer peripheral portion 335 may be 0%; that is, the outer peripheral portion 335 may be formed of a solid material.

### (Arrangement of Spacer 140 and Wick 150)

Referring next to FIG. 6(C), the arrangement of the spacer 140 and the wick 150 will be described. First, the spacer 140 and the wick 150 are disposed in overlapping relation to each other. The outer periphery of the wick 150 is held by the spacer 140, which is a frame body. Pressing the outer periphery of the wick 150 with the spacer 140 helps prevent leakage of the working fluid in the liquid phase to the outside. Since the spacer 140 includes the bridging portion 315, it holds not only the outer periphery of the wick 150 but also the central portion of the plate surface of the wick 150. As a result, even in situations where the wick 150 is susceptible to warping, the bridging portion 315 restrains deformation of the wick 150.

Here, the outer peripheral portion 335 of the wick 150 is located in its region to be pressed by the spacer 140. The outer peripheral portion 335 has a relatively smaller pore size and higher strength than the central portion 331, which is a region of the wick 150 that is not pressed by the spacer 140. Therefore, even when a large force is applied from the spacer 140 due to, for example, an external impact, damage to the wick 150 may be prevented.

Also, the outer peripheral portion 335 of the wick 150 faces the O-ring grooves 317. Since the outer peripheral portion 335 coming into contact with the O-rings S1 disposed in the O-ring grooves 317 has a smaller pore size, the contact area with the O-rings S1 increases. This leads to more reliable sealing.

The spacer opening 312 of the spacer 140 is located at a position overlapping the central portion 331 of the wick 150. The first spacer opening 316 and the second spacer opening 318 of the spacer 140 are located at positions overlapping the first liquid-side opening 226 and the second liquid-side opening 228 of the liquid reservoir portion 220 (see FIG. 4). This arrangement helps prevent the flow of the working fluid in the liquid phase from the liquid reservoir portion 220 toward the wick 150 from being obstructed by the spacer 140.

The outer periphery of the wick 150 may be viewed as a region having a predetermined width (e.g., 3 mm to 30 mm) from the outer edge of the plate surface of the wick 150. The outer periphery of the wick 150 may also be viewed as a region surrounding a region through which the working fluid in the liquid phase passes.

### <Operation of Evaporator 101>

FIG. 7 is a schematic cross-sectional view taken along line VII-VII in FIG. 2.

Referring next to FIGS. 1 and 7, the operation of the evaporator 101 will be described.

As shown in FIG. 7, the working fluid in the liquid phase having entered the compensation chamber 210 through the liquid line 109 then flows into the liquid-phase fluid accommodation region 229 of the liquid reservoir portion 220 (see arrows A11). The working fluid in the liquid phase then passes through the spacer opening 312 of the spacer 140 and permeates the wick 150 (see arrow A12). As the working fluid in the liquid phase moves through the wick 150 by capillary force, it is heated by heat from the heating element 50 and thereby vaporized. The vaporized working fluid flows along the vapor grooves 293 (see arrow A13). The working fluid in the gas phase then passes through the gas-phase fluid guide region 289 and flows out from the outlet 284 (see arrow A17). The working fluid in the gas phase exiting the outlet 284 is delivered to the vapor line 107.

Meanwhile, the working fluid having entered the condenser 105 (see FIG. 1) through the vapor line 107 and liquefied therein flows into the evaporator 101 through the liquid line 109. The working fluid having entered the evaporator 101 passes through the compensation chamber 210 and permeates the wick 150 again. In this manner, the above cycle is repeated without interruption of the flow of the working fluid in the wick 150. The heat generated in the heating element 50 is transported from the evaporator 101 to the condenser 105.

### <Arrangement of Evaporator 101>

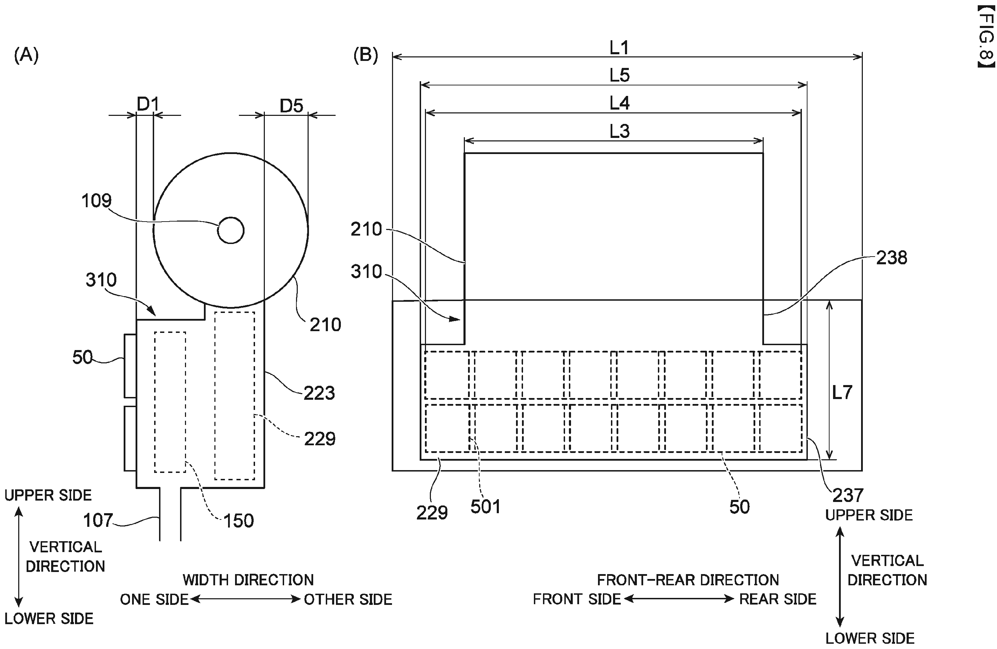

FIG. 8 illustrates the arrangement of the evaporator 101. Specifically, FIG. 8(A) illustrates a schematic configuration of the evaporator 101 as seen from the front side in the front-rear direction, while FIG. 8(B) illustrates a schematic configuration of the evaporator 101 as seen from one side in the width direction.

Referring next to FIGS. 7 and 8, the arrangement of the evaporator 101 will be described.

First, as shown in FIG. 8(A), in the evaporator 101, the compensation chamber 210 and the evaporator main body 310 are arranged one above the other in the vertical direction. To further illustrate, in the evaporator 101, the compensation chamber 210 is located above the plate-shaped evaporator main body 310. This vertical arrangement of the compensation chamber 210 and the evaporator main body 310 helps reduce the dimension of the evaporator 101 in the horizontal direction.

In addition, the plate surface of the substantially plate-shaped evaporator main body 310 extends along the vertical direction, i.e., disposed in a vertical orientation. This reduces the dimension of the evaporator main body 310 in the horizontal direction. The vertical orientation of the evaporator main body 310 also helps reduce the bottom area of the liquid-phase fluid accommodation region 229 formed inside the evaporator main body 310. Reduction in the bottom area of the liquid-phase fluid accommodation region 229 ensures a height (depth) of the working fluid in the liquid phase accommodated in the liquid-phase fluid accommodation region 229, even when the volume of the working fluid in the liquid phase is small. Thus, even when the volume of the working fluid in the liquid phase is small, the liquid surface of the working fluid in the liquid phase is less likely to be located below the wick 150, resulting in little decrease in thermal efficiency. In the illustrated example, a length of the evaporator main body 310 in the front-rear direction is relatively long. This allows the evaporator main body 310 to be cooled by air flowing in the front-rear direction around the outer periphery of the evaporator main body 310 as the automobile 1 travels.

Furthermore, even when the working fluid evaporates and generates bubbles on the surface of the wick 150 in the liquid-phase fluid accommodation region 229, the vertical orientation of the plate surface of the wick 150 causes such bubbles to flow upward (rise) along the plate surface of the wick 150. In other words, the vertical orientation of the plate surface of the wick 150 facilitates the separation of bubbles from the surface of the wick 150. This mitigates a reduction in thermal efficiency that may otherwise be caused by bubbles adhering to the surface of the wick 150.

In the example shown in FIG. 8(A), a distance from the heating element 50 to the compensation chamber 210 is relatively long. To further illustrate, the compensation chamber 210 is disposed at a position horizontally offset from directly above the heating element 50 (offset arrangement; see distance D1 in FIG. 8(A)). Furthermore, the curved outer peripheral surface of the compensation chamber 210 promotes air flow along the outer peripheral surface of the compensation chamber 210. As a result, air heated by the heating element 50 is less likely to stay around the outer periphery of the compensation chamber 210. These factors mitigate a temperature rise in the compensation chamber 210 that may otherwise be caused by heat generated in the heating element 50. Even in a configuration in which, unlike the illustrated example, the compensation chamber 210 is disposed directly above the heating element 50, the curved outer peripheral surface of the compensation chamber 210 may still prevent air heated by the heating element 50 from staying around the outer periphery of the compensation chamber 210.

As shown in FIG. 8(A), the compensation chamber 210 protrudes farther toward the other side in the width direction than the surface of the evaporator main body 310 on the other side in the width direction, i.e., the liquid-side lid body 223 (see distance D5 in FIG. 8(A)). As the compensation chamber 210 protrudes toward the side opposite to the heating element 50, the compensation chamber 210 is cooled by air. For example, the compensation chamber 210 is cooled by airflow from the lower side to the upper side in the vertical direction.

As shown in FIG. 8(B), a length L4 of the heating element 50 in the front-rear direction is longer than a length L3 of the compensation chamber 210 in the front-rear direction. This reduces heating of the compensation chamber 210 by the heating element 50.

A horizontal length L1 of the evaporator main body 310 is longer than the length L3 of the compensation chamber 210. A horizontal length L5 of the liquid-phase fluid accommodation region 229 formed inside the evaporator main body 310 is longer than the length L3 of the compensation chamber 210. The horizontal length L5 of the liquid-phase fluid accommodation region 229 is longer than a vertical length L7 of the liquid-phase fluid accommodation region 229. This ensures the volume of the space for accommodating the working fluid in the liquid phase while reducing the dimension of the liquid-phase fluid accommodation region 229 in the width direction, i.e., the thickness of the evaporator main body 310.

Non-limiting example dimensions of the components of the evaporator 101 are as follows. Specifically, as shown in FIG. 7, a height H1 of the evaporator 101 may be 50 mm to 500 mm, and a height H2 of the evaporator main body 310 may be 20 mm to 300 mm. A width W1 of the evaporator main body 310 may be 10 mm to 100 mm, a width W2 of the wick container 170 may be 5 mm to 50 mm, and an outer diameter W3 of the compensation chamber 210 may be 20 mm to 200 mm.

As shown in FIG. 8(B), the length L1 of the evaporator 101 (evaporator main body 310) may be 50 mm to 1000 mm, the length L3 of the compensation chamber 210 may be 30 mm to 800 mm, the length L4 of the heating element 50 may be 40 mm to 900 mm, and the length L5 of the liquid-phase fluid accommodation region 229 may be 50 mm to 1000 mm.

Although not described above, in the illustrated example, the heating element 50 is composed of an array of semiconductor elements 501, which are SiC semiconductors. To further illustrate, in the illustrated example, the heating element 50 has semiconductor elements 501 arranged in two rows. Note that the shape of the semiconductor elements 501 in the illustrated example is schematically shown, and there is no particular limitation on the shape of the semiconductor elements 501. There is also no particular limitation on the number of semiconductor elements 501 constituting the heating element 50.

### <Modifications>

Some modifications of the evaporator 101 will be described below. Hereinafter, elements similar to those in the above embodiment are denoted by the same reference numerals, and detailed descriptions thereof may be omitted.

### (Modifications of Wick 150)

In the above description, the wick 150 has been described as being a metal porous body; however, this is not limiting. That is, the wick 150 may be made of any material with a large number of pores, i.e., voids, therein. For example, the wick 150 may be formed of a resin porous body such as polytetrafluoroethylene (PTFE), a ceramic porous body, a glass porous body, porous fibers, or the like. Using a material having low thermal conductivity for the wick 150 can reduce heat leakage in the evaporator 101. When it is desired to further reduce heat leakage, it is preferable to use non-metallic materials, which generally have lower thermal conductivity than metals.

Any suitable method may be used to form the wick 150. For example, the wick 150 may be formed by placing metal powder (powder), such as copper, into a predetermined shape and sintering it. Alternatively, the wick 150 may be formed by placing a metal paste containing metal powder into a predetermined shape and sintering it. Still alternatively, the wick 150 may be formed by etching a plate-shaped member to provide a large number of fine pores. Still alternatively, the wick 150 may be formed using an additive manufacturing apparatus, a so-called 3D printer.

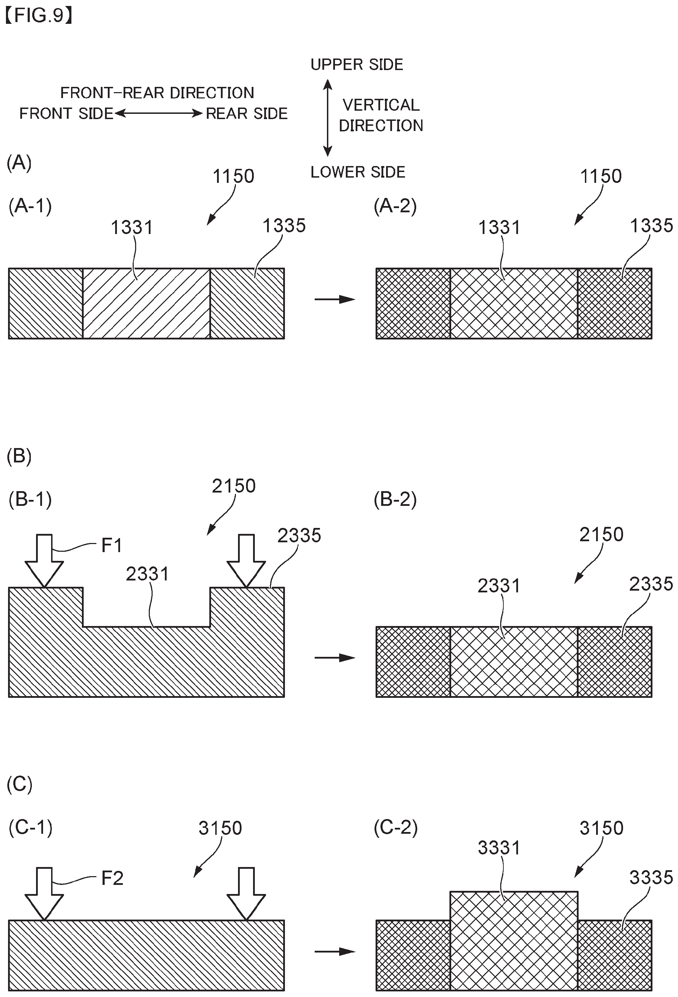

FIG. 9 illustrates a first modification.

In the above description, the wick 150 has difference pore sizes between the central portion 331 and the outer peripheral portion 335. When the wick 150 is formed by placing metal powder into a predetermined shape and sintering it, the wick 150 may be, but is not limited to being, formed by the following steps.

As shown in FIG. 9(A-1), metal powders having different particle sizes may be used for a central portion 1331 and an outer peripheral portion 1335. Specifically, materials different from each other are placed into predetermined shapes as the central portion 1331 and the outer peripheral portion 1335. Then, as shown in FIG. 9(A-2), sintering may be performed to form a wick 1150 having different pore sizes between the central portion 1331 and the outer peripheral portion 1335.

As shown in FIG. 9(B-1), the same metal powder may be used for a central portion 2331 and an outer peripheral portion 2335. Then, different treatments may be applied to the central portion 2331 and the outer peripheral portion 2335 to give them different pore sizes.

For example, as shown in FIG. 9(B-1), the same material is placed with different thicknesses at the central portion 2331 and the outer peripheral portion 2335. In the illustrated example, the metal powder in the outer peripheral portion 2335 is formed thicker than in the central portion 2331. Then, only the outer peripheral portion 2335 is pressed (see pressure F1) and compressed to make the thicknesses of the central portion 2331 and the outer peripheral portion 2335 uniform. Then, as shown in FIG. 9(B-2), sintering is performed to form a wick 2150 having a uniform thickness and a smaller pore size in the outer peripheral portion 2335.

Alternatively, as shown in FIG. 9(C-1), the same metal powder may be used and placed with the same thickness. Then, only an outer peripheral portion is pressed (see pressure F2) and compressed to make the outer peripheral portion 3335 thinner than a central portion 3331. Then, as shown in FIG. 9(C-2), sintering is performed to form a wick 3150 with the outer peripheral portion 335 having a relatively smaller thickness and a smaller pore size.

In the above description in relation to FIGS. 9(B) and 9(C) above, only the outer peripheral portion 3335 is pressed; however, this is not limiting. For example, both the central portion 2331 and the outer peripheral portion 2335 may be pressed. To further illustrate, the outer peripheral portion 3335 may be pressed with a higher pressure than the central portion 2331.

In the above description in relation to FIGS. 9(B) and 9(C), the wick 2150 and the like are formed by placing metal powder into a predetermined shape, pressing a part thereof, and then sintering it; however, this is not limiting. For example, after metal powder is placed into a predetermined shape and sintered, a part thereof may be pressed. To further illustrate, as shown in FIG. 9(B-1), the same material may be placed with different thicknesses for the central portion 2331 and the outer peripheral portion 2335 and sintered, after which the sintered body may be pressed to make the thicknesses of the central portion 2331 and the outer peripheral portion 2335 uniform. Alternatively, as shown in FIG. 9(C-1), the same material may be placed with the uniform thickness and sintered, after which the thickness of the outer peripheral portion 3335 may be made smaller than that of the central portion 3331. The process of pressing a part of the sintered body after sintering the metal powder may be viewed as a process for increasing strength (rigidity) of a partial region of the porous body.

In the above description, the toughness is varied by changing the pore size between the central portion 2331 and the outer peripheral portion 2335; however, this is not limiting. For example, the toughness may be varied by using different materials for the central portion 2331 and the outer peripheral portion 2335. In another example, the toughness may be varied by using different forming processes for the central portion 2331 and the outer peripheral portion 2335, such as by applying heat treatment only to the outer peripheral portion 2335.

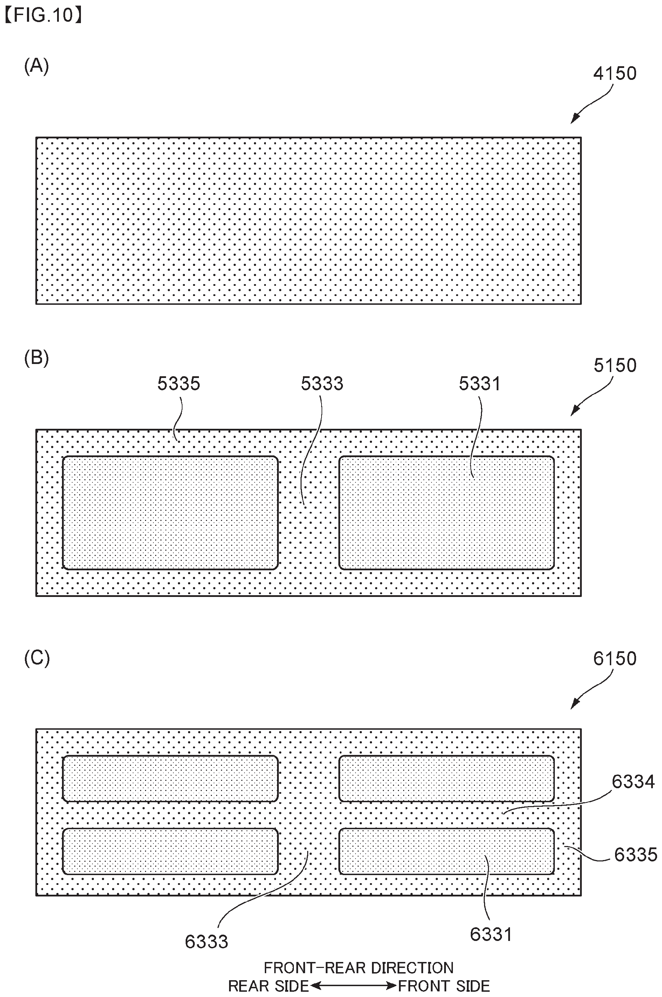

FIG. 10 illustrates a second modification.

In the above description, the central portion 331 of the wick 150 and the outer peripheral portion 335 thereof surrounding the central portion 331 have different pore sizes; however, the configuration of the wick 150 is not limited to this. For example, as shown in FIG. 10(A), the entire wick 4150 may be formed of a common material (for example, having a common pore size).

As shown in FIG. 10(B), in a configuration in which a wick 5150 includes a central portion 5331 and an outer peripheral portion 5335, a bridging portion 5333 may be provided at the center in the front-rear direction. The bridging portion 5333 is formed of the same material as the outer peripheral portion 5335. That is, the bridging portion 5333 is formed of a material different from that of the central portion 5331. The bridging portion 5333 is disposed at a position to be pressed by the bridging portion 315 of the spacer 140 (see FIG. 6(B)). By virtue of the relatively small pore size of the bridging portion 5333, damage to the wick 5150 may be prevented.

As shown in FIG. 10(C), in a configuration in which a wick 6150 includes a central portion 6331 and an outer peripheral portion 6335, bridging portions 6333 and 6334 that intersect each other may be provided. As with the bridging portion 5333, the bridging portions 6333 and 6334 are formed with relatively small pore sizes, which helps prevent damage to the wick 6150.

In the above description, the vapor guide protrusions 287 extending in the vertical direction are formed on the wick-side lid body 273 of the wick container 170; however, this is not limiting. It is sufficient that a flow path for the working fluid in the gas phase is formed in a region where the wick-side lid body 273 and the wick 150 are in contact with each other. For example, instead of, or in addition to, the vapor guide protrusions 287 of the wick-side lid body 273, protrusions or grooves extending in the vertical direction may be formed on the surface of the wick 150 facing the wick-side lid body 273.

In the above description, the spacer 140 is provided with the O-ring grooves 317 (see FIG. 6(A)) to receive the O-rings S1; however, this is not limiting. For example, the O-ring groove(s) 317 may be provided in the wick 150.

### (Modification of Spacer 140)

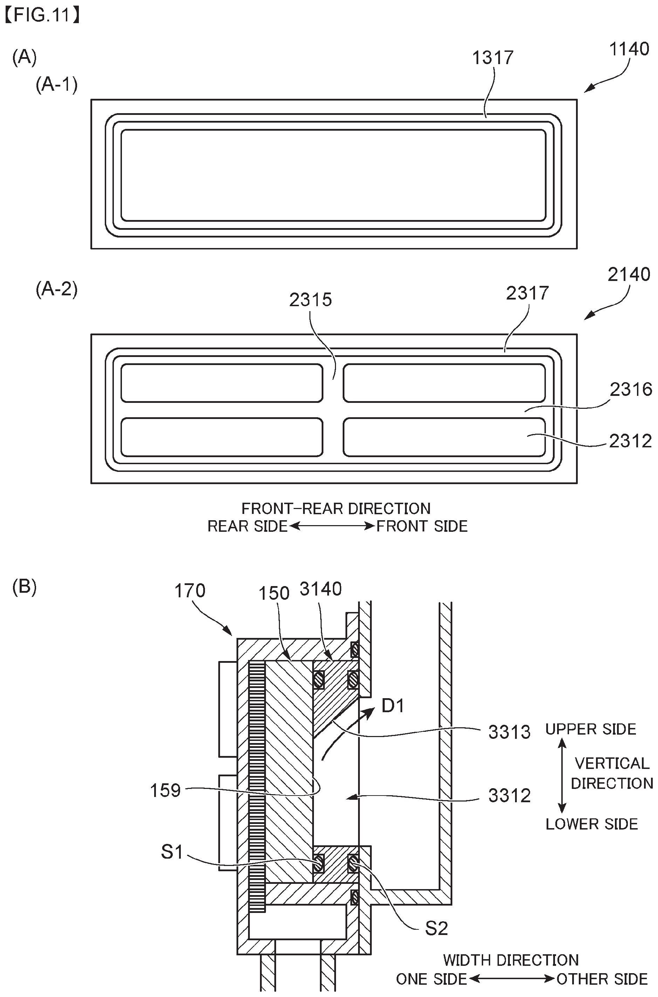

FIG. 11 illustrates a third modification.

In the above description, the spacer 140 includes the bridging portion 315; however, this is not limiting. For example, as shown in FIG. 11(A-1), a spacer 1140 may omit the bridging portion 315. In the illustrated example, an O-ring groove 1317 is provided along the outer periphery of the spacer 1140.

As shown in FIG. 11(A-2), a spacer 2140 may include bridging portions 2315 and 2316 that intersect each other. The spacer 2140 is formed with four spacer through-holes 2312. In the illustrated example, an O-ring groove 2317 is provided along the outer periphery of the spacer 2140. Unlike the illustrated example, multiple (four) O-ring grooves 2317 may be provided at positions surrounding the respective spacer through-holes 2312.

As shown in FIG. 11(B), a spacer 3140 may include a taper 3313. The taper 3313 is formed in a region facing a spacer through-hole 3312. The taper 3313 is inclined such that it goes upward in the vertical direction as it proceeds toward the other side in the width direction. Even when the working fluid evaporates and generates bubbles on a surface 159 of the wick 150 facing the spacer through-hole 2312, the bubbles are guided by the taper 3313 located above, allowing the bubbles to be discharged from the spacer through-hole 2312 (see arrow D1). This helps prevent bubbles generated on the surface 159 of the wick 150 from remaining in the upper space in the spacer through-hole 2312 and reducing the heat exchange rate of the wick 150.

Although not shown in the figures, the spacer 140 may be omitted in a configuration in which, unlike the above embodiment, the wick 150 is supported by the liquid-phase fluid container 110 and the wick container 170.

### (Other Modifications)

In the above description, the liquid-phase fluid container 110 is cylindrical; however, this is not limiting. For example, the liquid-phase fluid container 110 may have other shapes such as a cuboid or a cube. Further, the liquid-phase fluid container 110 may be omitted as long as the working fluid in the liquid phase is stably supplied to the wick 150.

In the above description, the central axis of the liquid-phase fluid container 110 and the plate surface of the wick 150 extend along the front-rear direction; however, this is not limiting. For example, the central axis of the liquid-phase fluid container 110 and the plate surface of the wick 150 may extend in perpendicular orientations with respect to each other.

In the above description, the condenser 105 includes the fins 701. Here, cooling by the fins 701 may be natural cooling or forced cooling. To further illustrate, the condenser 105 may include a blower fan and be configured to cool the fins 701 by an airflow generated by the blower fan.

In the above description, the wick 150 is plate-shaped, and the spacer 140 presses the outer periphery of the wick 150. Here, the configuration of the spacer 140 is not limited to the one described above as long as the spacer 140 is configured to press a side surface of the wick 150 in the space accommodating the working fluid in the liquid phase. For example, the spacer 140 may press multiple portions that are located on the outer periphery of a side surface of the wick 150 and spaced apart from each other. Alternatively, the spacer 140 may press one or more portions of a side surface of the wick 150, including the center of the plate surface. Still alternatively, the spacer 140 may press the center of the wick 150 in the longitudinal direction. Also, the wick 150 is not limited to being plate-shaped. For example, the wick 150 may have a block shape (cuboid shape) having a large dimension in the thickness direction, or may have other shapes such as a cylindrical shape or a spherical shape.

In the above description, the loop heat pipe 10 is used to cool the heating element 50 as a semiconductor provided in the automobile 1; however, this is not limiting. For example, the loop heat pipe 10 may be provided in moving bodies other than automobiles. To further illustrate, the loop heat pipe 10 may be provided in ships, railway vehicles, motorcycles, bicycles, drones, or the like. The loop heat pipe 10 may also be provided in devices other than moving bodies, such as computer devices including servers and personal computers, or batteries including household solar cells and fuel cells.

The techniques disclosed herein relate to, as described above, a heat exchanger including an evaporator provided with an evaporating body, the evaporating body being configured to absorb heat from outside and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator. The evaporator has an interior thereof partitioned by the evaporating body and includes: a liquid-phase fluid accommodation chamber provided on one side of the evaporating body and configured to accommodate the working fluid in the liquid phase; and a gas-phase fluid accommodation chamber provided on an opposite side of the evaporating body from the liquid-phase fluid accommodation chamber and configured to accommodate the working fluid in the gas phase. The evaporator includes a pressing member provided closer to the liquid-phase fluid accommodation chamber with respect to the evaporating body and configured to press a side surface of the evaporating body facing the liquid-phase fluid accommodation chamber. The evaporating body includes a pressed portion configured to be pressed by the pressing member, the pressed portion having higher toughness than a portion of the evaporating body that is not pressed by the pressing member.

Preferably, the evaporating body is plate-shaped, and the pressing member is configured to press an outer periphery of a plate surface of the evaporating body.

Preferably, the evaporating body has the plate surface elongated in one direction, and the pressing member includes: an outer peripheral frame portion configured to press the outer periphery of the evaporating body; and a central pressing portion extending in a direction intersecting the one direction and configured to connect central portions of the outer peripheral frame portion in the one direction and to press the plate surface of the evaporating body.

Preferably, the evaporator includes a liquid-phase fluid container defining the liquid-phase fluid accommodation chamber therein, and the liquid-phase fluid container includes a support portion configured to support the central pressing portion of the pressing member.

Preferably, the pressing member includes: a plurality of openings formed on both sides of the central pressing portion and configured to allow the working fluid in the liquid phase to flow therethrough toward the evaporating body; and a plurality of sealing members positioned on the plate surface of the evaporating body so as to surround the respective openings.

Preferably, the pressing member includes: an opening configured to allow the working fluid in the liquid phase to flow therethrough toward the evaporating body; and a sealing member positioned on the side surface of the evaporating body so as to surround the opening.

Preferably, the evaporator includes a liquid-phase fluid container defining the liquid-phase fluid accommodation chamber therein, and the pressing member has a lower thermal conductivity than the liquid-phase fluid container.

Preferably, the pressing member includes: an opening configured to allow the working fluid in the liquid phase to flow therethrough toward the evaporating body; and an inclined surface located above the opening and facing the opening, the inclined surface being inclined upward as it extends away from the side surface of the evaporating body.

Preferably, the pressed portion of the evaporating body has a smaller pore size than a portion of the evaporating body that is not pressed by the pressing member.

In another aspect, the techniques disclosed herein relate to a heat exchanger including an evaporator provided with an evaporating body, the evaporating body being configured to absorb heat from outside and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator. The evaporator has an interior thereof partitioned by the evaporating body and includes: a liquid-phase fluid accommodation chamber provided on one side of the evaporating body and configured to accommodate the working fluid in the liquid phase; and a gas-phase fluid accommodation chamber provided on an opposite side of the evaporating body from the liquid-phase fluid accommodation chamber and configured to accommodate the working fluid in the gas phase. The evaporator includes a pressing member provided closer to the liquid-phase fluid accommodation chamber with respect to the evaporating body and configured to press a side surface of the evaporating body facing the liquid-phase fluid accommodation chamber. The evaporating body includes a high-strength portion configured to be pressed by the pressing member, the high-strength portion having higher strength than a portion of the evaporating body that is not pressed by the pressing member.

In still another aspect, the techniques disclosed herein relate to a heat exchanger including an evaporator provided with a plate-shaped evaporating body, the evaporating body being configured to absorb heat from outside and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator. The evaporator has an interior thereof partitioned by the plate-shaped evaporating body and includes: a liquid-phase fluid accommodation chamber provided on one side of the evaporating body and configured to accommodate the working fluid in the liquid phase; and a gas-phase fluid accommodation chamber provided on an opposite side of the evaporating body from the liquid-phase fluid accommodation chamber and configured to accommodate the working fluid in the gas phase. The evaporator includes a pressing member provided closer to the liquid-phase fluid accommodation chamber with respect to the evaporating body and configured to press an outer periphery of a plate surface of the evaporating body facing the liquid-phase fluid accommodation chamber. The evaporating body has the plate surface elongated in a horizontal direction, and the outer periphery of the plate surface of the evaporating body has a smaller pore size than a central portion of the plate surface. The pressing member includes: an outer peripheral frame portion configured to press the outer periphery of the evaporating body; and a central pressing portion extending in a vertical direction and configured to connect central portions of the outer peripheral frame portion in the horizontal direction and to press the plate surface of the evaporating body.

In still another aspect, the techniques disclosed herein relate to an evaporator including an evaporating body configured to absorb heat from outside and evaporate a liquid-phase working fluid into a gas phase while moving the working fluid by capillary forces, the evaporator being configured to allow the working fluid in the gas phase evaporated in the evaporating body to flow out and to be circulated back into the evaporator after condensation. The evaporator has an interior thereof partitioned by the evaporating body and includes: a liquid-phase fluid accommodation chamber provided on one side of the evaporating body and configured to accommodate the working fluid in the liquid phase; and a gas-phase fluid accommodation chamber provided on an opposite side of the evaporating body from the liquid-phase fluid accommodation chamber and configured to accommodate the working fluid in the gas phase. The evaporator includes a pressing member provided closer to the liquid-phase fluid accommodation chamber with respect to the evaporating body and configured to press a side surface of the evaporating body facing the liquid-phase fluid accommodation chamber. The evaporating body includes a pressed portion configured to be pressed by the pressing member, the pressed portion having higher toughness than a portion of the evaporating body that is not pressed by the pressing member.

In still another aspect, the techniques disclosed herein relate to a device including: a heating element; and a heat exchanger including an evaporator provided with an evaporating body, the evaporating body being configured to absorb heat from the heating element and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator. The evaporator has an interior thereof partitioned by the evaporating body and includes: a liquid-phase fluid accommodation chamber provided on one side of the evaporating body and configured to accommodate the working fluid in the liquid phase; and a gas-phase fluid accommodation chamber provided on an opposite side of the evaporating body from the liquid-phase fluid accommodation chamber and configured to accommodate the working fluid in the gas phase. The evaporator includes a pressing member provided closer to the liquid-phase fluid accommodation chamber with respect to the evaporating body and configured to press a side surface of the evaporating body facing the liquid-phase fluid accommodation chamber. The evaporating body includes a pressed portion configured to be pressed by the pressing member, the pressed portion having higher toughness than a portion of the evaporating body that is not pressed by the pressing member.

In still another aspect, the techniques disclosed herein relate to a moving body including: a drive source; a heating element configured to control the drive source; and a heat exchanger including an evaporator provided with an evaporating body, the evaporating body being configured to absorb heat from the heating element and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator. In the moving body driven by the drive source, the evaporator has an interior thereof partitioned by the evaporating body and includes: a liquid-phase fluid accommodation chamber provided on one side of the evaporating body and configured to accommodate the working fluid in the liquid phase; and a gas-phase fluid accommodation chamber provided on an opposite side of the evaporating body from the liquid-phase fluid accommodation chamber and configured to accommodate the working fluid in the gas phase. The evaporator includes a pressing member provided closer to the liquid-phase fluid accommodation chamber with respect to the evaporating body and configured to press a side surface of the evaporating body facing the liquid-phase fluid accommodation chamber. The evaporating body includes a pressed portion configured to be pressed by the pressing member, the pressed portion having higher toughness than a portion of the evaporating body that is not pressed by the pressing member. The evaporator includes a housing whose interior is partitioned by the evaporating body to define the liquid-phase fluid accommodation chamber and the gas-phase fluid accommodation chamber therein. The housing is disposed with a longitudinal direction thereof extending in a horizontal direction and along a traveling direction of the moving body.

In recent years, the development of electric vehicles has been actively pursued as one of the measures for environmental protection. Such development of electric vehicles has been accompanied by improvements in the performance of semiconductors that control the motors of electric vehicles. However, such improvements in semiconductor performance lead to an increase in the amount of heat generated by semiconductors, resulting in a need for, among others, a heat exchanger that can remove heat flux from semiconductors with high efficiency. Meanwhile, the interior of an automobile vehicle body has a limited space, and it is desirable to reduce the dimensions of devices such as a heat exchanger for cooling semiconductors.

Accordingly, the techniques disclosed herein can also be understood as aiming to produce a head exchanger and other devices with reduced dimensions.

With the above object in mind, the technique disclosed herein can be understood as follows. That is, the techniques disclosed herein relate to a heat exchanger including an evaporator provided with a plate-shaped evaporating body, the evaporating body being configured to absorb heat from outside and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator. The evaporator includes: a liquid reservoir configured to store the working fluid in the liquid phase; a liquid-phase fluid container provided below the liquid reservoir in a vertical direction and configured to accommodate the working fluid in the liquid phase flowing down from the liquid reservoir; the evaporating body disposed with a plate surface thereof extending along the vertical direction and configured to evaporate the working fluid in the liquid phase accommodated in the liquid-phase fluid container; and a gas-phase fluid container provided on an opposite side of the evaporating body from the liquid-phase fluid container and configured to accommodate the working fluid in the gas phase.

In the heat exchanger according to claim 1, the liquid-phase fluid container includes a liquid-phase fluid accommodation chamber configured to accommodate the working fluid in the liquid phase, and the liquid-phase fluid accommodation chamber is longer in the horizontal direction than in the vertical direction.

Preferably, the liquid-phase fluid accommodation chamber includes a first portion located below the liquid reservoir and a second portion located below the first portion, and the first portion has a shorter dimension in the horizontal direction than the second portion.

Preferably, the liquid reservoir has a shorter dimension in the horizontal direction than the second portion.

Preferably, the evaporator includes a pressing member provided closer to the liquid-phase fluid accommodation chamber with respect to the evaporating body and configured to press an outer periphery of a plate surface of the evaporating body facing the liquid-phase fluid accommodation chamber.

Preferably, the evaporating body has the plate surface elongated in one direction, and the pressing member includes: an outer peripheral frame portion configured to press the outer periphery of the evaporating body; and a central pressing portion extending in a direction intersecting the one direction and configured to connect central portions of the outer peripheral frame portion in the one direction and to press the plate surface of the evaporating body.

Preferably, the gas-phase fluid container includes a heat-receiving surface configured to receive heat from an external heating element provided thereon, and the liquid reservoir is disposed at a position above the heating element in the vertical direction and offset from the heating element in the horizontal direction.

Preferably, the liquid reservoir protrudes farther than the liquid-phase fluid container in the horizontal direction toward a side opposite to the heating element.

Preferably, the liquid reservoir has a cylindrical shape with an axial direction thereof extending in the horizontal direction.

Preferably, the liquid-phase fluid container and the gas-phase fluid container constitute a plate-shaped housing with a plate surface thereof extending along the vertical direction.

In another aspect, the techniques disclosed herein relate to a heat exchanger including an evaporator provided with a plate-shaped evaporating body, the evaporating body being configured to absorb heat from outside and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator. The evaporator includes: a liquid reservoir of a cylindrical shape with an axial direction thereof extending in the horizontal direction, the liquid reservoir being configured to store the working fluid in the liquid phase; a liquid-phase fluid container provided below the liquid reservoir in a vertical direction and configured to accommodate the working fluid in the liquid phase flowing down from the liquid reservoir; the evaporating body disposed with a plate surface thereof extending along the vertical direction and configured to evaporate the working fluid in the liquid phase accommodated in the liquid-phase fluid container; and a gas-phase fluid container provided on an opposite side of the evaporating body from the liquid-phase fluid container and configured to accommodate the working fluid in the gas phase. The liquid-phase fluid container and the gas-phase fluid container constitute a plate-shaped housing with a plate surface thereof extending along the vertical direction. The liquid-phase fluid container includes a liquid-phase fluid accommodation chamber configured to accommodate the working fluid in the liquid phase. The liquid-phase fluid accommodation chamber is longer than the liquid reservoir in the horizontal direction.

In still another aspect, the techniques disclosed herein relate to an evaporator including a plated-shaped evaporating body configured to absorb heat from outside and evaporate a liquid-phase working fluid into a gas phase while moving the working fluid by capillary forces, the evaporator being configured to allow the working fluid in the gas phase evaporated in the evaporating body to flow out and to be circulated back into the evaporator after condensation. The evaporator includes: a liquid reservoir configured to store the working fluid in the liquid phase; a liquid-phase fluid container provided below the liquid reservoir in a vertical direction and configured to accommodate the working fluid in the liquid phase flowing down from the liquid reservoir; the evaporating body disposed with a plate surface thereof extending along the vertical direction and configured to evaporate the working fluid in the liquid phase accommodated in the liquid-phase fluid container; and a gas-phase fluid container provided on an opposite side of the evaporating body from the liquid-phase fluid container and configured to accommodate the working fluid in the gas phase.

In still another aspect, the techniques disclosed herein relate to a device including: a heating element; and a heat exchanger including an evaporator provided with a plate-shaped evaporating body, the evaporating body being configured to absorb heat from the heating element and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator. The evaporator includes: a liquid reservoir configured to store the working fluid in the liquid phase; a liquid-phase fluid container provided below the liquid reservoir in a vertical direction and configured to accommodate the working fluid in the liquid phase flowing down from the liquid reservoir; the evaporating body disposed with a plate surface thereof extending along the vertical direction and configured to evaporate the working fluid in the liquid phase accommodated in the liquid-phase fluid container; and a gas-phase fluid container provided on an opposite side of the evaporating body from the liquid-phase fluid container and configured to accommodate the working fluid in the gas phase.

In still another aspect, the techniques disclosed herein relate to a moving body including: a drive source; a heating element configured to control the drive source; and a heat exchanger including an evaporator provided with a plate-shaped evaporating body, the evaporating body being configured to absorb heat from the heating element and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator. In the moving body driven by the drive source, the evaporator includes: a liquid reservoir of a cylindrical shape with an axial direction thereof extending in a horizontal direction, the liquid reservoir being configured to store the working fluid in the liquid phase; a liquid-phase fluid container provided below the liquid reservoir in a vertical direction and configured to accommodate the working fluid in the liquid phase flowing down from the liquid reservoir; the evaporating body disposed with a plate surface thereof extending along the vertical direction and configured to evaporate the working fluid in the liquid phase accommodated in the liquid-phase fluid container; and a gas-phase fluid container provided on an opposite side of the evaporating body from the liquid-phase fluid container and configured to accommodate the working fluid in the gas phase. The liquid-phase fluid container and the gas-phase fluid container constitute a plate-shaped housing with a plate surface thereof extending along the vertical direction. The axial direction of the liquid reservoir and the plate surface of the housing extend along a traveling direction of the moving body.

While various embodiments and modifications have been described above, it will be readily understood that they may be combined with one another.

It will be also understood that teachings of the present disclosure are in no way limited to the above embodiments, and may be implemented in various ways without departing from the subject matter of the present disclosure.

The loop heat pipe 10 is an example of the heat exchanger. The automobile 1 is an example of the device and the moving body. The wick 150 is an example of the evaporating body. The liquid-phase fluid accommodation region 229 is an example of the liquid-phase fluid accommodation chamber. The gas-phase fluid guide region 289 is an example of the gas-phase fluid accommodation chamber. The spacer 140 is an example of the pressing member and the outer peripheral frame portion. The outer peripheral portion 335 is an example of the pressed portion and the high-strength portion. The bridging portion 315 is an example of the central pressing portion. The liquid reservoir portion 220 is an example of the liquid-phase fluid container. The bridging portion 225 is an example of the support portion. The taper 3313 is an example of the inclined surface. The motor 30 is an example of the drive source. The compensation chamber 210 is an example of the liquid reservoir. The narrow frame portion 238 is an example of the first portion. The wide frame portion 237 is an example of the second portion.

### Reference Signs List

- 1: Automobile
- 50: Heating element
- 10: Loop heat pipe
- 101: Evaporator
- 110: Liquid-phase fluid container
- 130: Housed body
- 140: Spacer
- 150: Wick

## Claims

1. A heat exchanger including an evaporator provided with an evaporating body, the evaporating body being configured to absorb heat from outside and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator, wherein
the evaporator has an interior thereof partitioned by the evaporating body and comprises:
a liquid-phase fluid accommodation chamber provided on one side of the evaporating body and configured to accommodate the working fluid in the liquid phase; and
a gas-phase fluid accommodation chamber provided on an opposite side of the evaporating body from the liquid-phase fluid accommodation chamber and configured to accommodate the working fluid in the gas phase,
the evaporator comprises a pressing member provided closer to the liquid-phase fluid accommodation chamber with respect to the evaporating body and configured to press a side surface of the evaporating body facing the liquid-phase fluid accommodation chamber, and
the evaporating body comprises a pressed portion configured to be pressed by the pressing member, the pressed portion having higher toughness than a portion of the evaporating body that is not pressed by the pressing member.

2. The heat exchanger according to claim 1, wherein
the evaporating body is plate-shaped, and
the pressing member is configured to press an outer periphery of a plate surface of the evaporating body.

3. The heat exchanger according to claim 2, wherein
the evaporating body has the plate surface elongated in one direction, and
the pressing member comprises:
an outer peripheral frame portion configured to press the outer periphery of the evaporating body; and
a central pressing portion extending in a direction intersecting the one direction and configured to connect central portions of the outer peripheral frame portion in the one direction and to press the plate surface of the evaporating body.

4. The heat exchanger according to claim 3, wherein
the evaporator comprises a liquid-phase fluid container defining the liquid-phase fluid accommodation chamber therein, and
the liquid-phase fluid container comprises a support portion configured to support the central pressing portion of the pressing member.

5. The heat exchanger according to claim 3 or 4, wherein the pressing member comprises:
a plurality of openings formed on both sides of the central pressing portion and configured to allow the working fluid in the liquid phase to flow therethrough toward the evaporating body; and
a plurality of sealing members positioned on the plate surface of the evaporating body so as to surround the respective openings.

6. The heat exchanger according to claim 1, wherein the pressing member comprises:
an opening configured to allow the working fluid in the liquid phase to flow therethrough toward the evaporating body; and
a sealing member positioned on the side surface of the evaporating body so as to surround the opening.

7. The heat exchanger according to claim 6, wherein
the evaporator comprises a liquid-phase fluid container defining the liquid-phase fluid accommodation chamber therein, and
the pressing member has a lower thermal conductivity than the liquid-phase fluid container.

8. The heat exchanger according to claim 1, wherein the pressing member comprises:
an opening configured to allow the working fluid in the liquid phase to flow therethrough toward the evaporating body; and
an inclined surface located above the opening and facing the opening, the inclined surface being inclined upward as the inclined surface extends away from the side surface of the evaporating body.

9. The heat exchanger according to claim 1, wherein the pressed portion of the evaporating body has a smaller pore size than a portion of the evaporating body that is not pressed by the pressing member.

10. A heat exchanger including an evaporator provided with an evaporating body, the evaporating body being configured to absorb heat from outside and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator, wherein
the evaporator has an interior thereof partitioned by the evaporating body and comprises:
a liquid-phase fluid accommodation chamber provided on one side of the evaporating body and configured to accommodate the working fluid in the liquid phase; and
a gas-phase fluid accommodation chamber provided on an opposite side of the evaporating body from the liquid-phase fluid accommodation chamber and configured to accommodate the working fluid in the gas phase,
the evaporator comprises a pressing member provided closer to the liquid-phase fluid accommodation chamber with respect to the evaporating body and configured to press a side surface of the evaporating body facing the liquid-phase fluid accommodation chamber, and the evaporating body comprises a high-strength portion configured to be pressed by the pressing member, the high-strength portion having higher strength than a portion of the evaporating body that is not pressed by the pressing member.

11. A heat exchanger including an evaporator provided with a plate-shaped evaporating body, the evaporating body being configured to absorb heat from outside and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator, wherein the evaporator has an interior thereof partitioned by the plate-shaped evaporating body and comprises:
a liquid-phase fluid accommodation chamber provided on one side of the evaporating body and configured to accommodate the working fluid in the liquid phase; and
a gas-phase fluid accommodation chamber provided on an opposite side of the evaporating body from the liquid-phase fluid accommodation chamber and configured to accommodate the working fluid in the gas phase,
the evaporator comprises a pressing member provided closer to the liquid-phase fluid accommodation chamber with respect to the evaporating body and configured to press an outer periphery of a plate surface of the evaporating body facing the liquid-phase fluid accommodation chamber,
the evaporating body has the plate surface elongated in a horizontal direction,
the outer periphery of the plate surface of the evaporating body has a smaller pore size than a central portion of the plate surface, and
the pressing member comprises:
an outer peripheral frame portion configured to press the outer periphery of the evaporating body; and
a central pressing portion extending in a vertical direction and configured to connect central portions of the outer peripheral frame portion in the horizontal direction and to press the plate surface of the evaporating body.

12. An evaporator including an evaporating body configured to absorb heat from outside and evaporate a liquid-phase working fluid into a gas phase while moving the working fluid by capillary forces, the evaporator being configured to allow the working fluid in the gas phase evaporated in the evaporating body to flow out and to be circulated back into the evaporator after condensation, wherein
the evaporator has an interior thereof partitioned by the evaporating body and comprises:
a liquid-phase fluid accommodation chamber provided on one side of the evaporating body and configured to accommodate the working fluid in the liquid phase; and
a gas-phase fluid accommodation chamber provided on an opposite side of the evaporating body from the liquid-phase fluid accommodation chamber and configured to accommodate the working fluid in the gas phase,
the evaporator comprises a pressing member provided closer to the liquid-phase fluid accommodation chamber with respect to the evaporating body and configured to press a side surface of the evaporating body facing the liquid-phase fluid accommodation chamber, and
the evaporating body comprises a pressed portion configured to be pressed by the pressing member, the pressed portion having higher toughness than a portion of the evaporating body that is not pressed by the pressing member.

13. A device comprising:
a heating element; and
a heat exchanger including an evaporator provided with an evaporating body, the evaporating body being configured to absorb heat from the heating element and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator, wherein
the evaporator has an interior thereof partitioned by the evaporating body and comprises:
a liquid-phase fluid accommodation chamber provided on one side of the evaporating body and configured to accommodate the working fluid in the liquid phase; and
a gas-phase fluid accommodation chamber provided on an opposite side of the evaporating body from the liquid-phase fluid accommodation chamber and configured to accommodate the working fluid in the gas phase,
the evaporator comprises a pressing member provided closer to the liquid-phase fluid accommodation chamber with respect to the evaporating body and configured to press a side surface of the evaporating body facing the liquid-phase fluid accommodation chamber, and the evaporating body comprises a pressed portion configured to be pressed by the pressing member, the pressed portion having higher toughness than a portion of the evaporating body that is not pressed by the pressing member.

14. A moving body comprising:
a drive source;
a heating element configured to control the drive source; and
a heat exchanger including an evaporator provided with an evaporating body, the evaporating body being configured to absorb heat from the heating element and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator, wherein
in the moving body driven by the drive source, the evaporator has an interior thereof partitioned by the evaporating body and comprises:
a liquid-phase fluid accommodation chamber provided on one side of the evaporating body and configured to accommodate the working fluid in the liquid phase; and
a gas-phase fluid accommodation chamber provided on an opposite side of the evaporating body from the liquid-phase fluid accommodation chamber and configured to accommodate the working fluid in the gas phase,
the evaporator comprises a pressing member provided closer to the liquid-phase fluid accommodation chamber with respect to the evaporating body and configured to press a side surface of the evaporating body facing the liquid-phase fluid accommodation chamber,
the evaporating body comprises a pressed portion configured to be pressed by the pressing member, the pressed portion having higher toughness than a portion of the evaporating body that is not pressed by the pressing member,
the evaporator comprises a housing whose interior is partitioned by the evaporating body to define the liquid-phase fluid accommodation chamber and the gas-phase fluid accommodation chamber therein, and
the housing is disposed with a longitudinal direction thereof extending in a horizontal direction and along a traveling direction of the moving body.

15. A heat exchanger including an evaporator provided with a plate-shaped evaporating body, the evaporating body being configured to absorb heat from outside and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator, wherein the evaporator comprises:
a liquid reservoir configured to store the working fluid in the liquid phase;
a liquid-phase fluid container provided below the liquid reservoir in a vertical direction and
configured to accommodate the working fluid in the liquid phase flowing down from the liquid reservoir;
the evaporating body disposed with a plate surface thereof extending along the vertical direction and configured to evaporate the working fluid in the liquid phase accommodated in the liquid-phase fluid container; and
a gas-phase fluid container provided on an opposite side of the evaporating body from the liquid-phase fluid container and configured to accommodate the working fluid in the gas phase.

16. The heat exchanger according to claim 15, wherein
the liquid-phase fluid container comprises a liquid-phase fluid accommodation chamber configured to accommodate the working fluid in the liquid phase, and
the liquid-phase fluid accommodation chamber is longer in a horizontal direction than in the vertical direction.

17. The heat exchanger according to claim 16, wherein
the liquid-phase fluid accommodation chamber comprises a first portion located below the liquid reservoir and a second portion located below the first portion, and
the first portion has a shorter dimension in the horizontal direction than the second portion.

18. The heat exchanger according to claim 17, wherein the liquid reservoir has a shorter dimension in the horizontal direction than the second portion.

19. The heat exchanger according to claim 15, wherein the evaporator comprises a pressing member provided closer to the liquid-phase fluid container with respect to the evaporating body and configured to press an outer periphery of a plate surface of the evaporating body facing the liquid-phase fluid container.

20. The heat exchanger according to claim 19, wherein
the evaporating body has the plate surface elongated in one direction, and
the pressing member comprises:
an outer peripheral frame portion configured to press the outer periphery of the evaporating body; and
a central pressing portion extending in a direction intersecting the one direction and configured to connect central portions of the outer peripheral frame portion in the one direction and to press the plate surface of the evaporating body.

21. The heat exchanger according to claim 15, wherein
the gas-phase fluid container comprises a heat-receiving surface configured to receive heat from an external heating element provided thereon, and
the liquid reservoir is disposed at a position above the heating element in the vertical direction and offset from the heating element in a horizontal direction.

22. The heat exchanger according to claim 21, wherein the liquid reservoir protrudes farther than the liquid-phase fluid container in the horizontal direction toward a side opposite to the heating element.

23. The heat exchanger according to claim 21 or 22, wherein the liquid reservoir has a cylindrical shape with an axial direction thereof extending in the horizontal direction.

24. The heat exchanger according to claim 23, wherein the liquid-phase fluid container and the gas-phase fluid container constitute a plate-shaped housing with a plate surface thereof extending along the vertical direction.

25. A heat exchanger including an evaporator provided with a plate-shaped evaporating body, the evaporating body being configured to absorb heat from outside and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator, wherein the evaporator comprises:
a liquid reservoir of a cylindrical shape with an axial direction thereof extending in a horizontal direction, the liquid reservoir being configured to store the working fluid in the liquid phase;
a liquid-phase fluid container provided below the liquid reservoir in a vertical direction and configured to accommodate the working fluid in the liquid phase flowing down from the liquid reservoir;
the evaporating body disposed with a plate surface thereof extending along the vertical direction and configured to evaporate the working fluid in the liquid phase accommodated in the liquid-phase fluid container; and
a gas-phase fluid container provided on an opposite side of the evaporating body from the liquid-phase fluid container and configured to accommodate the working fluid in the gas phase, the liquid-phase fluid container and the gas-phase fluid container constitute a plate-shaped housing with a plate surface thereof extending along the vertical direction,
the liquid-phase fluid container comprises a liquid-phase fluid accommodation chamber configured to accommodate the working fluid in the liquid phase, and
the liquid-phase fluid accommodation chamber is longer than the liquid reservoir in the horizontal direction.

26. An evaporator including a plated-shaped evaporating body configured to absorb heat from outside and evaporate a liquid-phase working fluid into a gas phase while moving the working fluid by capillary forces, the evaporator being configured to allow the working fluid in the gas phase evaporated in the evaporating body to flow out and to be circulated back into the evaporator after condensation, wherein
the evaporator comprises:
a liquid reservoir configured to store the working fluid in the liquid phase;
a liquid-phase fluid container provided below the liquid reservoir in a vertical direction and configured to accommodate the working fluid in the liquid phase flowing down from the liquid reservoir;
the evaporating body disposed with a plate surface thereof extending along the vertical direction and configured to evaporate the working fluid in the liquid phase accommodated in the liquid-phase fluid container; and
a gas-phase fluid container provided on an opposite side of the evaporating body from the liquid-phase fluid container and configured to accommodate the working fluid in the gas phase.

27. A device comprising:
a heating element; and
a heat exchanger including an evaporator provided with a plate-shaped evaporating body, the evaporating body being configured to absorb heat from the heating element and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator,
wherein
the evaporator comprises:
a liquid reservoir configured to store the working fluid in the liquid phase;
a liquid-phase fluid container provided below the liquid reservoir in a vertical direction and
configured to accommodate the working fluid in the liquid phase flowing down from the liquid reservoir;
the evaporating body disposed with a plate surface thereof extending along the vertical direction and configured to evaporate the working fluid in the liquid phase accommodated in the liquid-phase fluid container; and
a gas-phase fluid container provided on an opposite side of the evaporating body from the liquid-phase fluid container and configured to accommodate the working fluid in the gas phase.

28. A moving body comprising:
a drive source;
a heating element configured to control the drive source; and
a heat exchanger including an evaporator provided with a plate-shaped evaporating body, the evaporating body being configured to absorb heat from the heating element and evaporate a liquid-phase working fluid into a gas phase while moving the working fluid by capillary forces, the heat exchanger being configured to condense the working fluid in the gas phase introduced from the evaporator and circulate the working fluid in a liquid phase back into the evaporator,
wherein
in the moving body driven by the drive source, the evaporator comprises:
a liquid reservoir of a cylindrical shape with an axial direction thereof extending in a horizontal direction, the liquid reservoir being configured to store the working fluid in the liquid phase;
a liquid-phase fluid container provided below the liquid reservoir in a vertical direction and configured to accommodate the working fluid in the liquid phase flowing down from the liquid reservoir;
the evaporating body disposed with a plate surface thereof extending along the vertical direction and configured to evaporate the working fluid in the liquid phase accommodated in the liquid-phase fluid container; and
a gas-phase fluid container provided on an opposite side of the evaporating body from the liquid-phase fluid container and configured to accommodate the working fluid in the gas phase, the liquid-phase fluid container and the gas-phase fluid container constitute a plate-shaped housing with a plate surface thereof extending along the vertical direction, and
the axial direction of the liquid reservoir and the plate surface of the housing extend along a traveling direction of the moving body.
